# EUROPEAN PATENT APPLICATION

(11) **EP 4 528 368 A1**
(43) Date of publication of application: **26.03.2025**
(21) Application number: 22946987.9
(22) Date of filing: 18.11.2022
(51) Int. Cl.: G02F 1/1335, H01L 27/15, H01L 25/075, H01L 27/12, H01L 33/60, H01L 33/56, G02F 1/13357, G02B 13/08, G02B 3/00

(54) **LED PANEL USING SEMICONDUCTOR LIGHT-EMITTING ELEMENT, PRODUCTION METHOD THEREFOR, AND DISPLAY DEVICE COMPRISING LED PANEL**

(30) Priority: 13.06.2022 WO PCT/KR2022/008272
(71) Applicant: LG Electronics Inc., Yeongdeungpo-gu Seoul 07336 (KR)
(72) Inventor: JEONG, Chansung, Seoul 06772 (KR); PARK, Sangtae, Seoul 06772 (KR); LEE, Sangyeol, Seoul 06772 (KR); OH, Jeongtak, Seoul 06772 (KR); KIM, Sungkyoon, Seoul 06772 (KR); LEE, Jongwoo, Seoul 06772 (KR)
(74) Representative: Schornack, Oliver
(86) International application number: PCT/KR2022/018261
(87) International publication number: WO 2023/243782

(57) **Abstract**

This LED panel comprising: a base substrate including circuit wiring; a plurality of light-emitting diodes disposed to form an array on the base substrate; a side optical layer located laterally to the plurality of light-emitting diodes and including a diffusing agent; and a plurality of upper optical layers respectively located on top of the plurality of light-emitting diodes and including a diffusing agent can provide uniform light in all directions through uniform light distribution by reducing color difference for different viewing angles that occurs due to the structure of a semiconductor light-emitting diode.

## Description

### [Technical Field]

The present disclosure relates to a display device using a semiconductor light emitting-element. In particular, the present disclosure relates to a display device that uniformly improves the light distribution of an RGB chip and improves the luminance with the structure of a semiconductor light emitting-element.

### [Background Art]

With the increasing development of information society, the demand for display devices is also increasing in various forms. In response to this trend, various display devices, for example, Liquid Crystal Display (LCD), Field Emission Display (FED), Plasma Display Panel (PDP), an electroluminescent device, etc. have recently been developed.

A liquid crystal panel of the LCD may include a liquid crystal layer, may further include a thin film transistor (TFT) substrate and a color filter substrate that are arranged to face each other on the basis of the liquid crystal panel interposed therebetween, and may display an image using light provided from a backlight unit.

A light emitting diode (LED) is a semiconductor light emitting device known for converting electric current into light, and has been used as a light source for display images in electronic devices including information and communication devices since 1962, when red LEDs using GaAsP compound semiconductors were commercialized, along with GaP:N-based green LEDs. Compared to filament-based light-emitting elements, semiconductor light-emitting elements have various advantages such as long service life, low power consumption, excellent initial drive characteristics, and high vibration resistance.

Here, the semiconductor light-emitting element may include at least one of a mini LED and a micro LED. While there is no precise definition of size, the micro LED may be an LED having a size of several to tens of microns, and the mini LED may be an LED having a size tens of times that of the micro LED.

Display devices using semiconductor light-emitting elements can be thinned, and can be implemented in various shapes. For example, the light-emitting elements may enable implementation of a curved display device or a flexible display device.

LEDs can be used for outdoor displays due to their high luminance, which makes them highly visible outdoors. In particular, unit panels composed of light-emitting elements may be arranged in a tiling manner to implement a large screen.

However, in the case of the large screen, the angle at which a user looks at the screen varies depending on the position on the screen. The viewing angle of light varies depending on the color, and thus the color of an image perceived by a user on a side of the screen is different from the color of the image perceived when the user is in front of the screen.

### [Disclosure]

### [Technical Problem]

An object of one embodiment is to provide a display device using a semiconductor light-emitting element.

Another object of one embodiment is to provide a display device using a semiconductor light-emitting element that is capable of reflecting light emitted from the side of an LED chip mounted on a substrate back into the element to improve the efficiency of an LED chip, increase brightness, and reduce power consumption.

Another object of one embodiment is to provide a display device that minimizes light distribution by reducing the color difference among viewing angles caused by the structure of a semiconductor light emitting diode.

Another object of one embodiment is to provide a display device that minimizes bright line caused by assembly steps between modules by increasing light extraction efficiency in the forward direction by implementing a uniform light distribution of an RGB chip.

### [Technical Solution]

In one aspect of the present disclosure, a light emitting diode (LED) panel may include a base substrate including circuit wiring, a plurality of LEDs disposed in an array on the base substrate, a side optical layer positioned on a lateral side of the plurality of LEDs, the side optical layer containing a diffusion agent, and a plurality of upper optical layers, each positioned on a top surface of the plurality of LEDs and containing a diffusion agent.

The upper optical layers may have a size corresponding to a size of the top surface of the LEDs.

The upper optical layers may have a height to diameter ratio of 0.6 or less.

A top surface of the upper optical layers may include a curved surface.

The upper optical layers may contain silicone, wherein a difference in refractive index between the diffusion agent and the silicone may be greater than or equal to 0.3.

The diffusion agent may include a silicone diffusion agent containing at least one of SiO₂, ZrO₂, ZnO, or TiO₂.

The side optical layer may have a height corresponding to a height of the LEDs, and fills a gap between the LEDs.

The side optical layer may contain silicone, wherein a difference in refractive index between the diffusion agent and the silicone may be greater than or equal to 0.3.

The side optical layer may reflect or absorb light emitted from a lateral side of the LEDs.

The LED panel may further include a black layer positioned on a top surface of the side optical layer.

The black layer may contain carbon or an ultraviolet absorbing material.

The black layer may formed by carbonizing the side optical layer with a laser (It may include a layer of silicone or epoxy containing carbon).

The LED panel may further include a transparent resin layer covering the side optical layer and the upper optical layers and positioned on top surfaces of the side optical layer and the upper optical layers.

The transparent resin layer may contain scattering particles.

The LED panel may further include at least one of an anti-reflection (AR) (or anti-glare (AG)) film, a low reflection (LR) film, or an anti-finger (AF) film laminated over the transparent resin layer.

The LEDs may be stacked LEDs each having light-emitting chips of red, blue, and green colors sequentially stacked on the base substrate.

The LEDs may include a parallel-type LED having light-emitting chips of red, blue, and green colors arranged side by side.

In another aspect of the present disclosure, a method of producing a light emitting diode (LED) panel may include providing a base substrate having circuit wiring, mounting a plurality of LEDs in an array on the base substrate, forming an upper optical layer on a top surface of each of the plurality of LEDs, forming a side optical layer positioned on a lateral side of the plurality of LEDs, and forming a black layer by carbonizing a top surface of the side optical layer by radiating a laser onto the side optical layer.

In another aspect of the present disclosure, a display device may include a display module having a plurality of light emitting diode (LED) panels disposed in an array, a frame allowing the plurality of LED panels to mounted therein, and a controller connected to the display module to control the display module, wherein each of the LED panels may include a base substrate including circuit wiring, a plurality of LEDs disposed in an array on the base substrate, a side optical layer positioned on a lateral side of the plurality of LEDs, the side optical layer containing a diffusion agent, and an upper optical layers positioned on a top surface of each of the LEDs and containing a diffusion agent.

### [Advantageous Effects]

According to one embodiment of the present disclosure, a display device using a semiconductor light-emitting element may reflect light emitted from the side of an LED chip mounted on a substrate back into the element, thereby improving the efficiency of the LED chip, increasing brightness, and reducing power consumption.

By reducing the color difference among viewing angles caused by the structure of a semiconductor light emitting diode, uniform white light may be obtained in all directions through uniform light distribution.

Effects obtainable from the present embodiments are not limited by the above mentioned effects, and other unmentioned effects can be clearly understood from the above description by those having ordinary skill in the technical field to which the present disclosure pertains.

### [Description of Drawings]

FIG. 1 is a block diagram illustrating components of a display device according to the present disclosure.
FIG. 2 is a perspective view illustrating an example of the display device according to the present disclosure.
FIG. 3 is an exploded perspective view of a display panel according to the present disclosure.
FIG. 4 is a diagram illustrating an example of individual light emitting diodes.
FIG. 5 is a schematic diagram illustrating directions in which light is emitted from a light emitting diode.
FIG. 6 is a diagram illustrating a light distribution of a light emitting diode.
FIG. 7 is a cross-sectional view illustrating one embodiment of an LED panel according to one aspect of the present disclosure.
FIG. 8 is a diagram illustrating the color-specific beam angles of the light emitting diode of FIG. 7.
FIG. 9 is a diagram illustrating another embodiment of an LED panel according to one aspect of the present disclosure.
FIG. 10 is a diagram illustrating another embodiment of an LED panel according to one aspect of the present disclosure.
FIG. 11 is a diagram illustrating the shape of the numerical aperture (NA) output by color depending on presence/absence of an upper optical layer.
FIG. 12 is a diagram illustrating the color-specific beam angle of light emitted from a light emitting diode including an upper optical layer with a diffusion agent added.
FIG. 13 illustrates the color viewing angles of an LED panel according to one aspect of the present disclosure and a conventional LED panel.

### [Best Mode]

Description will now be given in detail according to exemplary embodiments disclosed herein, with reference to the accompanying drawings. For the sake of brief description with reference to the drawings, the same or equivalent components may be provided with the same reference numbers, and description thereof will not be repeated. In general, a suffix such as "module" and "unit" may be used to refer to elements or components. Use of such a suffix herein is merely intended to facilitate description of the specification, and the suffix itself is not intended to give any special meaning or function. In the present disclosure, that which is well-known to one of ordinary skill in the relevant art has generally been omitted for the sake of brevity. The accompanying drawings are used to help easily understand various technical features and it should be understood that the embodiments presented herein are not limited by the accompanying drawings. As such, the present disclosure should be construed to extend to any alterations, equivalents and substitutes in addition to those which are particularly set out in the accompanying drawings.

It will be understood that although the terms first, second, etc. may be used herein to describe various elements, these elements should not be limited by these terms. These terms are generally only used to distinguish one element from another.

It will be understood that when an element is referred to as being "connected with" another element, the element can be directly connected with the other element or intervening elements may also be present. In contrast, when an element is referred to as being "directly connected with" another element, there are no intervening elements present.

A singular representation may include a plural representation unless it represents a definitely different meaning from the context.

Terms such as "include" or "has" are used herein and should be understood that they are intended to indicate an existence of several components, functions or steps, disclosed in the specification, and it is also understood that greater or fewer components, functions, or steps may likewise be utilized.

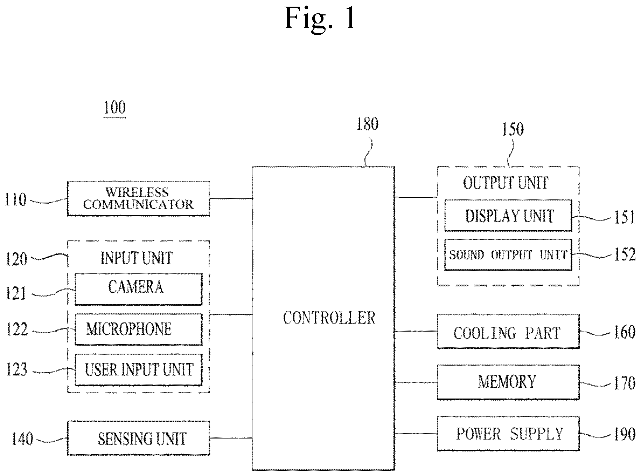

FIG. 1 is a block diagram illustrating a display device 100 related to the present disclosure.

The display device 100 may include a wireless communicator 110, an input unit 120, a sensing part 140, an output unit 150, a cooling part 160, a memory 170, a controller 180, and a power supply 190. The components shown in FIG. 1 are not essential to implement the display device 100, and the display device 100 described herein may have more or fewer components than those listed above.

More specifically, the wireless communicator 110 among the components may include one or more modules that enable wireless communication between the display device 100 and a wireless communication system, between the display device 100 and another display device 100, or between the display device 100 and an external server. Additionally, the wireless communicator 110 may include one or more modules that connect the display device 100 to one or more networks.

The wireless communicator 110 may include at least one of a mobile communication module, a wireless internet module, or a short-range communication module.

The input unit 120 may include a camera 121 or image input unit configured to input an image signal, a microphone 122 or audio input unit configured to input an audio signal, and a user input unit 123 (e.g., a touch key, a mechanical key, etc.) configured to input information from a user. Voice data or image data collected by the input unit 120 may be analyzed and processed as control commands from the user.

Recently, as a bezel of the display device 100 decreases in size, the number of display devices 100 each including a minimum number of input units 130 formed in a physical button exposed to the outside is rapidly increasing. Instead, a minimum number of physical buttons may be provided on the back or side surface of the display device 100. The display device may receive user input through the remote controller 200 through a touchpad or a user input interface unit 173 to be described later.

The sensing part 140 may include one or more sensors configured to sense at least one of information in the display device 100, information about the environment surrounding the display device 100, or user information. For example, the sensing part 140 may include at least one of a proximity sensor, an illumination sensor, a touch sensor, an RGB sensor, an infrared (IR) sensor, a finger scan sensor, an ultrasonic sensor, an optical sensor (e.g., the camera 121), a microphone (see 122), a battery gauge, an environmental sensor (e.g., a barometer, a hygrometer, a thermometer, a radiation detection sensor, a heat detection sensor, a gas detection sensor, etc.), a chemical sensor (e.g., an electronic nose, a healthcare sensor, or a biometric sensor, etc.). The display device 100 disclosed herein may utilize pieces of information sensed by at least two of these sensors in combination.

The controller 180 may check a state of the display device 100 based on information collected by the sensing unit 120, may notify the user of a problem, or may control the display device 100 to be kept in the best state.

The output unit 150 is configured to generate outputs related to visual, auditory, or tactile senses, and may include at least one of a display unit 151 and a sound output unit 152. The display unit 151 may be layered or integrally formed with the touch sensor, thereby implementing a touchscreen. Such a touch screen may function as the user input unit 123 to provide an input interface between the display device 100 and a user, and may provide an output interface between the display device 100 and the user.

The display 151 may be implemented as a plasma display panel (PDP), a liquid crystal display (LCD), an organic light emitting diode (OLED), a flexible display, etc. In addition, the display 151 may also be implemented as a three-dimensional (3D) display. The three-dimensional (3D) display 151 may be classified into a glassless-type 3D display and a glasses-type 3D display.

Meanwhile, the display 151 may be constituted by a touchscreen, whereby an input device may also be used in addition to an output device.

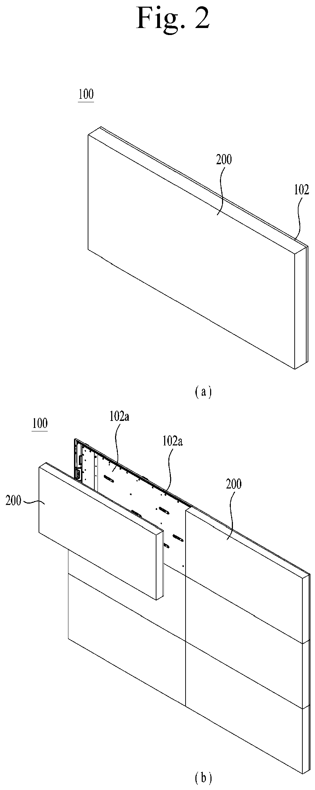

Referring to FIG. 2, the display device 100 according to the present disclosure may implement a large screen display 151 by arranging a plurality of display modules 200 in a grid shape.

The cooling part 160 represents a component that dissipates heat from the display device 100, and may include heat pipes or cooling fins, and a circulating fan configured to enhance air circulation within the display device 100, and a vent hole or the like.

When installed for the purpose of exhibition or advertisement, the display device 100 is operated for a long time and outputs high brightness to be clearly visible from the outside. Therefore, the heat generated by the display 151 and the controller 180 may affect each part of the display device 100, resulting in malfunctions, etc.. Therefore, a heat dissipation structure to dissipate the internal heat is very important.

In the display device 100, heat dissipation is implemented in various ways. Depending on how heat transfer is performed during the heat dissipation process, heat dissipation may be divided into air-cooling or water-cooling. In the case of air-cooling, heat dissipation efficiency can be increased by maximizing the surface area using heat fins or the like. In the case of water-cooling, heat dissipation efficiency can be increased by using a structure such as a heat pipe to guide flow and sealing of the heat transfer material.

Any of these cooling methods for heat dissipation may be used alone, or two or more of these methods may be used in combination as needed.

The memory 170 stores data that supports various functions of the display device 100. The memory 170 may store multiple application programs or applications running on the display device 100, data for operation of the display device 100, and instructions. At least some of these applications may be downloaded from an external server through wireless communication. In addition, at least some of these applications may be present on the display device 100 from the time of shipment for basic functions of the display device 100 (e.g., making and receiving calls, receiving messages, and sending messages). The applications may be stored in the memory 170, installed on the display device 100, and driven by the controller 180 to perform an operation (or function) of the display device 100.

In addition to operations related to the applications, the controller 180 generally controls the overall operation of the display device 100. The controller 180 may provide or process appropriate information or functions for the user by processing signals, data, information, etc. that are input or output through the components discussed above, or by driving applications stored in the memory 170.

Further, the controller 180 may control at least some of the components to run the applications stored in the memory 170. Further, the controller 180 may operate at least two of the components included in the display device 100 in combination to drive the applications.

The controller 180 may include at least one processor, and may control the overall operation of the display device 100 using the processor included therein. Here, the processor may be a general processor, such as a central processing unit (CPU). Of course, the processor may be a dedicated device, such as an ASIC, or another hardware-based processor.

An image signal processed by the controller 180 may be input to the display module 151, which may display an image corresponding to the image signal.

In addition, the image signal processed by the controller 180 may be input to an external output device through the external device interface unit 112.

In addition, the controller 180 may control the display device 100 according to a user command input through the user input interface unit or an internal program. Meanwhile, the controller 180 may control the display module 151 to display an image. At this time, the image displayed on the display module 151 may be a still image or video, or may be a 2D image or a 3D image.

Meanwhile, the controller 180 may perform control such that a predetermined 2D object is displayed in an image displayed on the display module 151. For example, the object may be at least one of a connected web screen (newspaper or magazine), an electronic program guide (EPG), various menus, a widget, an icon, a still image, video, and text.

Meanwhile, the controller 180 may modulate and/or demodulate a signal using an amplitude shift keying (ASK) method. Here, the amplitude shift keying (ASK) method may be a method of changing the amplitude of a carrier depending on a data value to modulate a signal or restoring an analog signal to a digital data value depending on the amplitude of a carrier.

For example, the controller 180 may modulate an image signal using the amplitude shift keying (ASK) method, and may transmit the modulated image signal through a wireless communication module.

For example, the controller 180 may demodulate and process an image signal received through the wireless communication module using the amplitude shift keying (ASK) method.

As a result, the display device 100 may easily transmit and receive a signal to and from another image display device disposed adjacent thereto without using a unique identifier, such as a media access control (MAC) address, or a complicated communication protocol, such as TCP/IP.

The power supply 190 may supply power to the components of the display device 100. In particular, the power supply may supply power to the controller 180, which may be implemented in the form of a system on chip (SOC), the display module 150 for image display, and the audio output unit 160 for audio output.

Specifically, the power supply 190 may include an AC/DC converter (not shown) configured to convert AC power into DC power and a DC/DC converter (not shown) configured to convert the level of the DC power.

The power supply 190 serves to distribute power supplied from the outside to the respective components of the display device. The power supply 190 may be directly connected to an external power supply in order to supply AC power, or may include a battery so as to be used by charging.

At least some of the components may operate in cooperation with each other to implement an operation, control, or control method of the display device 100 according to various embodiments described below. In addition, the operation, control, or control method of the display device 100 may be implemented on the display device 100 by driving at least one application program stored in the memory 170.

That is, two or more elements may be integrated into one element, or one element may be divided into two or more elements, as needed. In addition, the function performed by each block is for describing the embodiment of the present disclosure, and the specific operations and components thereof do not limit the scope of rights of the present disclosure.

FIG. 2 is a perspective view illustrating an example of the display device 100 according to the present disclosure. The display device may have a rectangular-shaped body with a pair of long sides and a pair of short sides.

The display device 100 can implement a display 151 in which images are output to a display module 200 integrally formed as shown in FIG. 2(a), and a plurality of display modules 200 may be arranged in a grid shape (in a tiling manner) as shown in FIG. 2(b) to form a large screen.

Since each of the display modules 200 uses a thin substrate or a sheet material, the display module 200 may be bent or damaged. The display module 200 may include a cover bottom 102. The cover bottom 102 may support a back surface of the display to form the rear exterior of the display device 100.

Referring to FIG. 2(a), the display device 100 using one display module 200 may use the cover bottom 102 corresponding to the size of the display module 200. When using the plurality of display modules 200 as shown in FIG. 2(b), the plurality of display modules 200 may be mounted to one cover bottom 102 in a grid shape.

The cover bottom 102 may use metal materials such as iron, aluminum, and magnesium for rigidity and heat generation. In order to effectively dissipate heat generated from the display module 200, a heat dissipation sheet 102a may be further provided on the front surface of the cover bottom 102. The heat dissipation sheet 102a may contain a material with high thermal conductivity, and may improve the heat dissipation effect by quickly spreading heat in a surface direction while transferring heat to the cover bottom 102.

In order to implement the display apparatus 100 with a large screen by arranging multiple display modules 200 as shown in FIG. 2(b), it is necessary to arrange the display modules 200 such that the gap therebetween is as narrow as possible. Even when the display modules 200 are arranged closely, the light emitted from the backlight allow the gap between the display modules 200 to be visible when the light is emitted from the side of the display modules 200 due to the characteristics of light.

The display device 100 in a tiled form may need to block light projected in a lateral direction to ensure that the boundaries between the display modules 200 are not visible.

Furthermore, when the display device 100 of a large screen is implemented in a tiling manner, the viewing angle of the user varies depending on the position of the display module 200. In this case, if the viewing angle is different depending on the type of light, the user may perceive different colors depending on the position on the screen.

In addition, regarding the viewing angle, when the display device 100 is installed outdoors, the user may view the display device 100 at the front, from a side, or from above or below. Accordingly, there is a need for a display module 200 that provides uniform colors of images to the user at viewing angles including the front view.

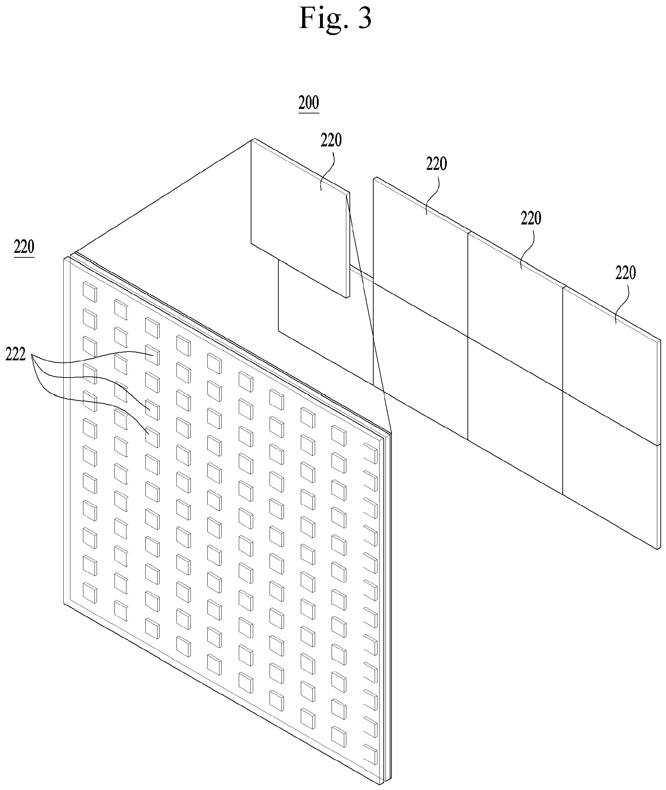

FIG. 3 is an exploded perspective view of the display panel 200 according to the present disclosure. Referring to FIG. 3, the display module 200 may further include multiple unit panels 220. The LED panel may include multiple LEDs 222 arranged in an array, and a controller configured to control the LEDs 222 may be disposed on the rear surface of the panel.

The LED panel 220 may be implemented by a semiconductor light-emitting element. In the present disclosure, a light emitting diode (LED) 222 is exemplified as a type of semiconductor light-emitting element that converts current into light.

Each LED 222 serves as a pixel that implements an image. The size of each LED 222 may be implemented as 1 mm or less, and the spacing between the LEDs 222, that is, the spacing between the pixels, may be implemented as 3 mm or less.

The LED 222 includes a light emitting chip 2224 that generates light, and further includes an encapsulation layer 2224 disposed thereon to protect the light emitting chip. The encapsulation layer 2224 serves to evenly diffuse light emitted from the light emitting chip 2223.

For the LEDs 222, as micro LEDs, which are smaller than the size of LEDs 222 employed as light sources in the past, are employed, the LED panel 220 may become thinner and more bendable due to the smaller size of the light sources.

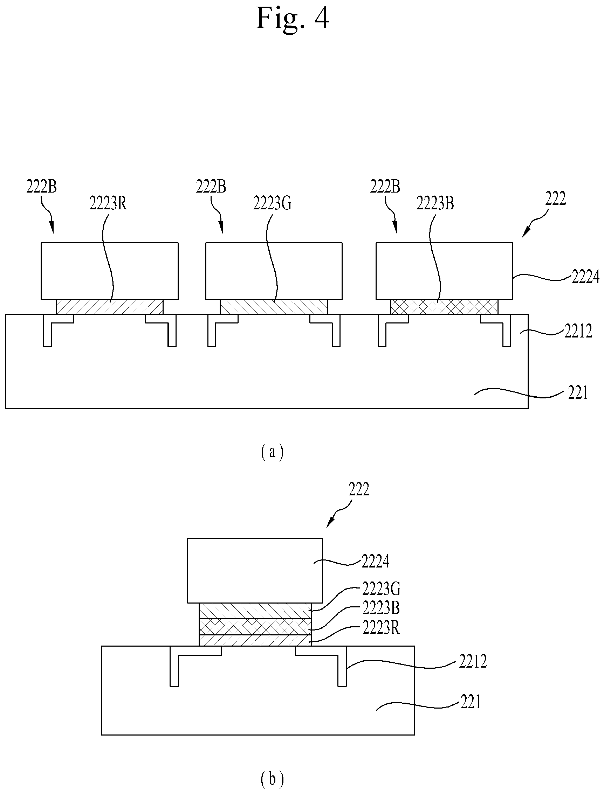

FIG. 4 is a diagram illustrating an example of individual LEDs 222. In FIG. 4(a), the LED 222 is a single chip containing only a light emitting chip 2223 distinguished by color, i.e., of one color. The chip of each color-specific LED 222R, 222G, 222B may be connected to an electrode 2212 on a base substrate 221.

In the figure, the top side is the front side from which the light of the LED panel 220 is emitted, facing forward of the display device 100. Hereinafter, it will be described as the top surface or the top side because it faces upward when the LED panel 220 is manufactured.

The three colors red (R), green (G), and blue (B) constitute one pixel. The three colors may be arranged alternately on the base substrate 221, or LEDs 222 with three colors in one package may be used.

In the figure, (b) shows a stacked LED 222, which may implement a single pixel by stacking light-emitting chips 2223R, 2223G, and 2223B of three colors. This configuration may result in a greater thickness than lateral arrangement of LEDs, it may reduce the size of an LED 22, allowing for a denser arrangement of LEDs 222. Thus, the LED panel 220 with finer pixels may be implemented. Also, since the colors are at different horizontal positions, differences in color according to the positions may be reduced during light synthesis.

For simplicity, the following description is based on the stacked LED 222 having light emitting chips 2223 disposed vertically, as shown in FIG. 4(b), but embodiments are not necessarily limited thereto. An LED module with light emitting chips 2223 disposed in a horizontal direction may also be used, as shown in FIG. 4(a).

The LEDs 222 may be disposed in an array on the base substrate 221 that includes an insulating material, as shown in FIG. 3. While the LEDs 2222 are shown to be large in size, they may actually be hundreds of microns in size and spaced more closely apart from each other than conventional light sources.

The base substrate 221 includes an insulating material, for example, polyimide (PI), although polyethylene naphthalate (PEN) and polyethylene terephthalate (PET) are also available. The base substrate 221 includes electrodes 2212 connected to each LED 222. The LEDs 222 may be turned on/off and supplied with power via the electrodes.

As the light sources, the packaged LEDs 222 are encapsulated to protect the R, G, and B color chips and synthesize the R, G, and B colored light to make white light, forming an encapsulation layer 2224.

The light-emitting chips of the LED 222 may each include a p-type electrode, a p-type semiconductor layer on which the p-type electrode is formed, an active layer formed on the p-type semiconductor layer, an n-type semiconductor layer formed on the active layer, and an n-type electrode disposed horizontally spaced apart from the p-type electrode on the n-type semiconductor layer.

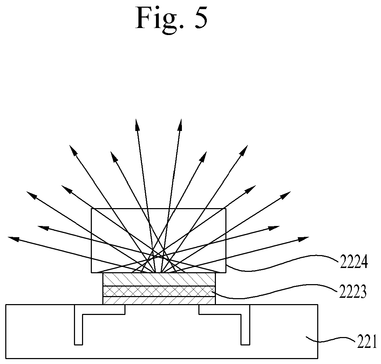

FIG. 5 is a schematic diagram illustrating directions in which light is emitted from the LED 222. Light may be emitted in a vertical direction from the top surface of the LED element, and the viewing angle of the light exceeds 100°. Accordingly, the light emitted from the LED 222 can be seen from a direction inclined at an angle from the vertical direction. The light projected in a lateral direction as described above may weaken the intensity of the light supplied forward, resulting in a decrease in luminance.

Further, the light emitted from the LED 222 may have a different light distribution due to different viewing angles for colors and different positions of the light-emitting elements for the colors.

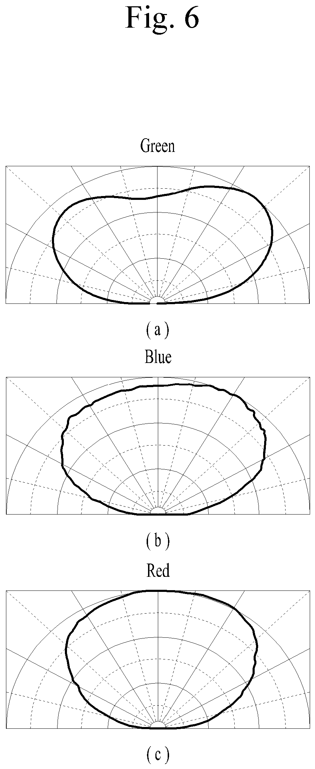

FIG. 6 is a diagram illustrating a light distribution of the LED 222, where (a) illustrates a light distribution of green, (b) illustrates a light distribution of blue, and (c) illustrates a light distribution of red. For blue and red colors, light emitted forward has the strongest intensity. On the other hand, for green, light spreads widely in the lateral direction.

The beam angle is an angle indicating the range of light emission based on the light distribution, which means the angular range in which the light spreads in the vertical direction. The beam angle of green light with a wide-spread light distribution may be 72°, while the beam angle of red or blue light may be 66° to 67°.

Therefore, when the LED panel 220 is viewed from a side direction at an angle from the front, it may appear to be pale green rather than completely white due to a large amount of emission of green light. On the other hand, the red color is strong in the forward direction, and thus reddish light may be emitted. Thus, it is necessary to configure the LED panel 220 to have a uniform distribution by color.

By guiding the light that spreads laterally such that the light is emitted forward, the green color emitted wide in the lateral direction will be emitted forward. When the beam angle of green is reduced, the green has a similar beam angle to other colors, and thus the light distribution and beam angle of each color may be adjusted to be similar.

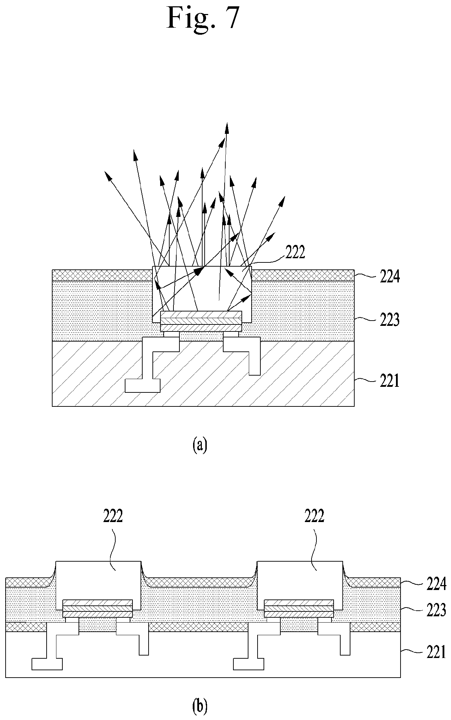

FIG. 7 is a cross-sectional view illustrating one embodiment of the LED panel 220 according to one aspect of the present disclosure.

According to the present disclosure, a diffusion layer 223 surrounding the lateral surfaces of the LED 222 may be added to guide light emitted in the lateral direction forward, as shown in FIG. 7. The side optical layer 223 is located on the lateral side of the LED 222 and may reflect light emitted from the lateral side of the LED 222 to guide the light forward. The side optical layer 223 closely contacts the lateral side of the LED 222 and may be formed by applying and curing a silicone epoxy on the base substrate 221 having the LEDs 222 arranged thereon in an array. In this case, the side optical layer 223 may be formed to have a height corresponding to or less than the height of the LED 222.

The side optical layer 223 may be applied by a jetting method using a printer that outputs epoxy, a molding method, or the like, and may be formed to cover the lateral side except the top surface of the LED 222.

The side optical layer 223 may be formed by applying a resin (epoxy) containing silicone and a diffusion agent to fill the space between the LEDs 222. The lateral sides of the side optical layer 223 make a close contact with the LEDs 222.

The top surface of the layer may be flat, as shown in FIG. 7(a), or concave, as shown in FIG. 7(b). The shape of the top surface may vary depending on the manufacturing method and the density of the silicone epoxy forming the side optical layer 223.

FIG. 7(a) illustrates the molding method, which forms a relatively flat top surface, and FIG. 7(b) illustrates the jetting method, which provides a lower viscosity than the molding method, and thus causes the layer to be higher around the wall portion in contact with the LED 222 due to surface tension.

The diffusion agent contained in the side optical layer 223 may include a material with a large refractive index, such as TiO₂, SiO₂, ZrO2, or ZnO. The diffusion agent may have a refractive index difference of 0.3 or more from silicone, which is the main material, and diffuse scattering may occur due to the difference in refractive index between the diffusion agent and the main material.

When the side optical layer 223 contains a bright colored diffusion agent, such as TiO2, a reflective effect may be further achieved due to the bright color. As shown in FIG. 7(a), light emitted in the lateral direction of the LED 222 may be reflected back to the encapsulation layer 2224, thereby increasing the amount of light emitted in the forward direction.

By reflecting the light emitted from the lateral side of the LED 222 and projecting the same forward, the amount of light emitted forward may be increased (resulting in improved light efficiency), and the luminance may be improved.

**[Table 1]**

| Color | Side optical layer X | Side optical layer O |
|---|---|---|
| Green (G) | 0.729 | 0.835 (15%_{↑}) |
| Red (R) | 0.813 | 0.88 (8%_{↑}) |
| Blue (B) | 0.82 | 0.87(6%_{↑}) |

Table 1 shows the light efficiency by color depending on presence/absence of the side optical layer 223. The light efficiency of all colors may be improved in the presence of the side optical layer 223, resulting in an overall increase of the light efficiency by more than 10%.

In particular, in the case of green, the luminance is significantly improved due to the high proportion of forward reflection of the light that spreads widely in the lateral direction. Also, the intensity, or luminance, of the light emitted in the forward direction is similar among the colors, and thus the synthesized light may have a uniform white color.

A black layer 224 may be further provided on the top surface of the side optical layer 223. The black layer 224 may be a resin layer containing a dark colored material such as carbon, and thus may absorb light. In the case where the side optical layer 223 is exposed on the front side, external light may be reflected by the side optical layer 223, lowering the visibility of the image output from the display device 100.

The black layer 224 may absorb the external light and prevent the visibility from being degraded by the external light, and may thus improve the visibility of the display device 100 even outdoors. Furthermore, it may increase the black contrast of the front surface of the display device 100 when the display device 100 is in a deactivated state, i.e., power-off state.

However, since the black layer 224 has absorbs light, it may hinder the light emitted by the LED 222 from being delivered forward if the layer overlaps the LED 222 or has a large area.

Accordingly, the black layer 224 may be formed on the top surface of the side optical layer 223 such that it is positioned on the lateral side of the LED 222 to minimize the area that overlaps the front of the LED 222. The black layer 224 may be implemented by carbonizing the silicone in the side optical layer 223 in radiating laser onto the side optical layer 223. In other words, the side optical layer 223 may be laser-irradiated.

The side optical layer 223 may contain carbon or a UV absorbing material and may change color in response to a specific wavelength of the laser.

In the case where the side optical layer 223 is implemented using dark-colored silicone, the separate black layer 224 may be omitted. Since the dark-colored side optical layer 223 is less reflective than the light-colored side optical layer 223, the effect of the layer recycling the light emitted in the lateral direction is reduced, but the process of producing the black layer 224 may be omitted, which has the advantage of minimizing the area where the black layer 224 overlaps the LED 222.

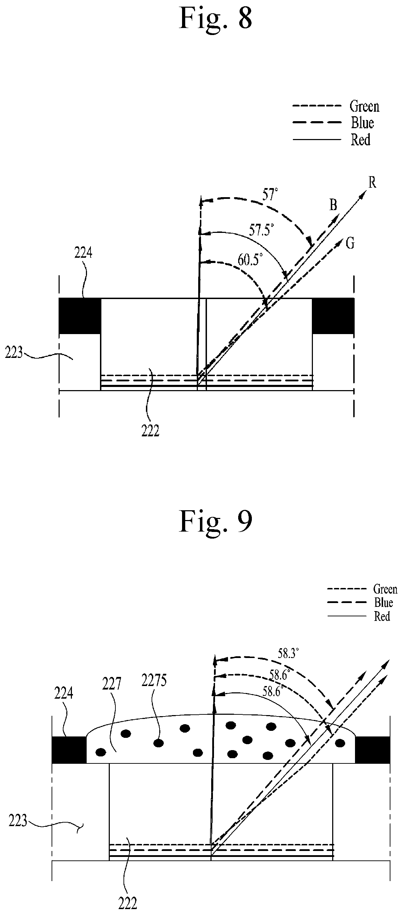

FIG. 8 is a diagram illustrating the color-specific beam angles of the LED 222 of FIG. 7. The side optical layer 223 may be used to narrow the beam angle toward the front to 60.5° for green, 57.5° for red, and 57° for blue.

Since the side optical layer 223 positioned on the lateral side reflects light forward, the beam angle may be narrower than in the embodiment without the side optical layer 223. It can be seen that the difference between the maximum and minimum of the beam angle is about 6° in the absence of the side optical layer 223, but it is reduced to about 3.5° by adding the side optical layer 223.

**Table 2**

| Color | Side optical layer X | Side optical layer O |
|---|---|---|
| Green (G) | 72° | 60.5 ° |
| Red (R) | 66° | 57.5 ° |
| Blue (B) | 66.5 ° | 57° |
| Δ angle | 6° | 3.5° |

However, the beam angle of green is still larger than those of red and blue, and therefore it is necessary to further compensate for this angle to reduce the color difference.

In the case of a stacked light source, the light emitting chips are stacked in the order of red, blue, and green the bottom, and thus the green light emitting chip 2223G is disposed closest to the top surface of the encapsulation layer 2224 of the LED 222.

The beam angle tends to be inversely proportional to the distance f from the emission surface to each light emitting chip 2223. Thus, the green color with the shortest distance has the largest beam angle. An upper optical layer 227 may be added to further reduce the beam angle of the green color.

FIG. 9 is a diagram illustrating another embodiment of the LED panel 220 according to one aspect of the present disclosure.

The figure illustrates the LED 222 of the LED panel 220, which further includes an upper optical layer 227. The upper optical layer 227 may be positioned on the top surface of the LED 222, as shown in FIG. 9(a). The upper optical layer 227 may refract light emitted from the LED 222 to adjust the beam angle. The beam angle may be reduced by about 3° to about 57.5° by refracting green light, which has a large beam angle.

The upper optical layer 227 may be formed on the LED 222 by a jetting process. The upper optical layer 227 may include transparent silicone and a diffusion agent 2275. The diffusion agent may include a material with a large refractive index, such as SiO₂, ZrO2, or ZnO.

The diffusion agent may have a refractive index difference of 0.3 or more from silicone, which is the main material, and diffuse scattering may occur due to the difference in refractive index between the diffusion agent and the main material.

Unlike the diffusion agent described above, a colorless material may be used for the diffusion agent in consideration of the light transmittance, or a smaller amount thereof than the diffusion agent may be added.

The side optical layer 223 does not need to have a high viscosity because the side optical layer 223 is injected between multiple LEDs 222 and side walls may be provided along the perimeter of the LED panel to prevent the silicone (epoxy) for forming the side optical layer 223 from overflowing. The upper optical layer 227, on the other hand, may employ silicone (epoxy) with a higher viscosity than the side optical layer 223 to sit on the top surface of the LED 222 without spreading excessively wide, and thus may form a curved surface on the top surface.

The size of the upper optical layer 227 may be configured such that the ratio of the diameter to the height is about 0.6 or less. As the viscosity increases, the surface of the upper optical layer 227 may become more convex.

The upper optical layer 227 may be formed after forming the side optical layer 223 as shown in FIG. 9, but may spread wide in the lateral direction. In this case, a gap may be formed between the black layer 224 and the LED 222.

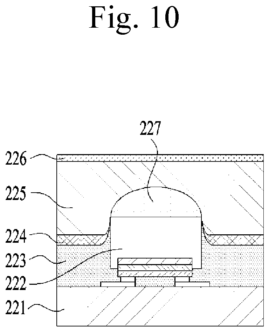

FIG. 10 is a diagram illustrating another embodiment of the LED panel 220 according to one aspect of the present disclosure. In this embodiment, the upper optical layer 227 is positioned on the LED 222 such that the size of the LEDs 222 is equal to the size of the upper optical layer 227.

The upper optical layer 227 may be formed first, and then the side optical layer 223 and the black layer 224 may be formed such that the upper optical layer 227 is positioned on the LED 222. After forming the upper optical layer 227, the side optical layer 223 may be formed and the black layer 224 may be realized by radiating a laser onto the top surface of the side optical layer 223. In this case, the gap between the LED 222 and the black layer 224 may be eliminated, allowing for more accurate control of the light emitted from the LED 222.

The laser-responsive diffusion agent (e.g., TiO2) is not included in the upper optical layer 227 such that, when the laser is radiated to form the black layer 224, only the side optical layer 223 reacts and the color of the upper optical layer 227 does not change. To protect the black layer 224 and the upper optical layer 227, a transparent resin layer 225 may be formed to cover the black layer 224 (or the side optical layer 223 if the black layer 224 is omitted) and the upper optical layer 227. The transparent resin layer 225 may include a silicone or epoxy material. The transparent resin may protect the LEDs 222 and the applied black layer 224 and may be configured such that the front surface of the display device 100 is flat.

A functional film layer 226 may be further disposed on the front surface of the transparent resin layer 225 to prevent light reflection by external light. The functional film layer 226 may include at least one of an anti-reflection (AR) (or anti-glare (AG)) film, a low reflection (LR) film, or an anti-finger (AF) film.

In addition, the film layer 226 including a color to have the transmittance greater than or equal to at least 30% may allow individual pixels (individual light-emitting elements) to be rarely visible when the LED panel is in the power-off state, achieving the effect of a dark screen.

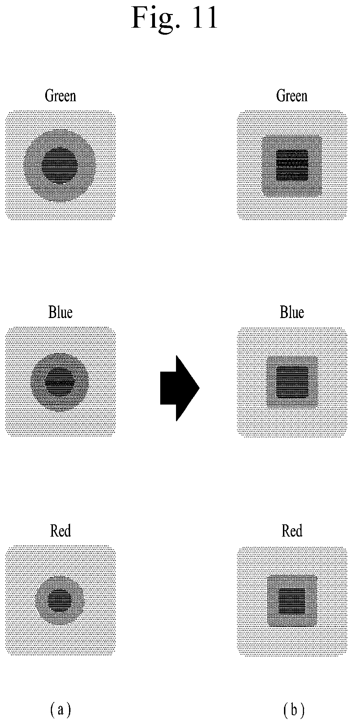

FIG. 11 is a diagram illustrating the shape of the numerical aperture (NA) output by color depending on presence/absence of the upper optical layer 227, wherein (a) illustrates an embodiment without the upper optical layer 227 and (b) illustrates an embodiment with the upper optical layer 227.

Referring to (a), it can be seen that the light intensity from a point light source in the center light source portion is strong, and the green light has the largest NA shape.

Referring to (b), which shows the NA of an embodiment including the upper optical layer 227, the NAs of the colors are similar in size and have a uniform square shape.

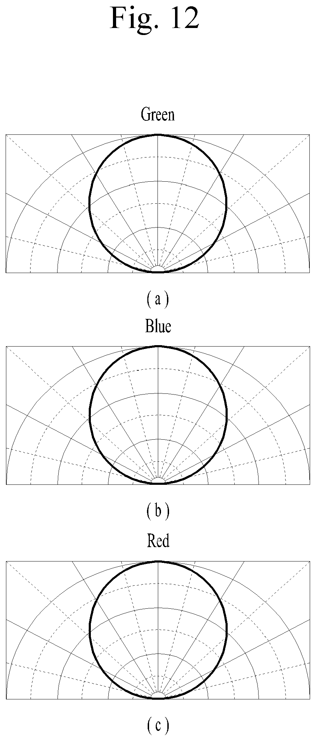

FIG. 12 is a diagram illustrating the color-specific beam angle of light emitted from the LED 222 including the upper optical layer 227 with a diffusion agent added. The beam angle is reduced and has a uniform shape rather than a shape that spreads wide in the lateral direction. In addition, uniform white light may be obtained with little difference by color.

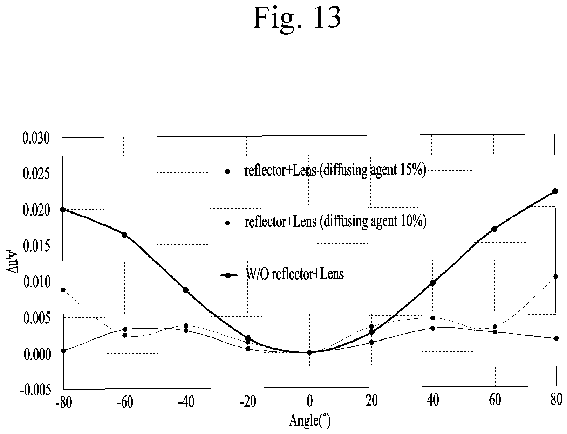

FIG. 13 illustrates the color viewing angles of an LED panel according to one aspect of the present disclosure and a conventional LED panel. The horizontal axis represents the viewing angle and the vertical axis represents the color difference. The wider the viewing has an effect of making certain colors more visible. The conventional LED panel shows that the color difference increases as the viewing angle increases. According to the present disclosure. A similar color difference may be obtained even when the viewing angle increases.

As the content of the diffusion agent in the upper optical layer increases, the effect of reducing the color difference according to the viewing angle may be enhanced. However, as the amount of the diffusion agent increases, luminance may be reduced. An appropriate amount of the diffusion agent is about 10 to 20%,

As described above, one embodiment of the present disclosure may provide the display device 100 using a semiconductor light-emitting element that may reflect light emitted from the lateral surface of an LED chip mounted on a substrate back into the element to improve the efficiency of the LED chip, while increasing luminance and reducing power consumption.

By reducing the color difference by viewing angle caused by the structure of the semiconductor LED 222, uniform white light may be obtained in all directions through uniform light distribution.

The above description is merely illustrative of the technical idea of the present disclosure. It will be apparent to those skilled in the art that various modifications and variations can be made in the present disclosure without departing from the spirit and scope of the disclosure.

Therefore, the embodiments disclosed herein are intended to illustrate and not to limit the technical ideas of the present disclosure, and the scope of the technical ideas of the present disclosure is not limited by these embodiments.

The detailed description above is not to be construed as limiting in any aspect and should be considered exemplary. The scope of this disclosure shall be determined by a reasonable interpretation of the appended claims. Thus, it is intended that the present disclosure cover the modifications and variations of this disclosure provided they come within the scope of the appended claims and their equivalents.

## Claims

1. A light emitting diode (LED) panel comprising:
a base substrate comprising circuit wiring;
a plurality of LEDs disposed in an array on the base substrate;
a side optical layer positioned on a lateral side of the plurality of LEDs, the side optical layer containing a diffusion agent; and
a plurality of upper optical layers, each positioned on a top surface of the plurality of LEDs and containing a diffusion agent.

2. The LED panel of claim 1, wherein the upper optical layers have a size corresponding to a size of the top surface of the LEDs.

3. The LED panel of claim 1, wherein the upper optical layers have a height to diameter ratio of 0.6 or less.

4. The LED panel of claim 1, wherein a top surface of the upper optical layers comprises a curved surface.

5. The LED panel of claim 1, wherein the upper optical layers contain silicone,
wherein a difference in refractive index between the diffusion agent and the silicone is greater than or equal to 0.3.

6. The LED panel of claim 5, wherein the diffusion agent comprises a silicone diffusion agent containing at least one of SiO₂, ZrO₂, or ZnO.

7. The LED panel of claim 1, wherein the side optical layer has a height corresponding to a height of the LEDs, and fills a gap between the LEDs.

8. The LED panel of claim 1, wherein the side optical layer contains silicone,
wherein a difference in refractive index between the diffusion agent and the silicone is greater than or equal to 0.3.

9. The LED panel of claim 1, wherein the side optical layer reflects or absorbs light emitted from a lateral side of the LEDs.

10. The LED panel of claim 1, further comprising:
a black layer positioned on a top surface of the side optical layer.

11. The LED panel of claim 10, wherein the black layer contains carbon or an ultraviolet absorbing material.

12. The LED panel of claim 10, wherein the black layer is formed by carbonizing the side optical layer with a laser.

13. The LED panel of claim 1, further comprising:
a transparent resin layer covering the side optical layer and the upper optical layers and positioned on top surfaces of the side optical layer and the upper optical layers.

14. The LED panel of claim 13, wherein the transparent resin layer contains scattering particles.

15. The LED panel of claim 13, further comprising:
at least one of an anti-reflection (AR) (or anti-glare (AG)) film, a low reflection (LR) film, or an anti-finger (AF) film laminated over the transparent resin layer.

16. The LED panel of claim 1, wherein the LEDs are stacked LEDs each having light-emitting chips of red, blue, and green colors sequentially stacked on the base substrate.

17. The LED panel of claim 1, wherein the LEDs comprise a parallel-type LED having light-emitting chips of red, blue, and green colors arranged side by side.

18. A method of producing a light emitting diode (LED) panel of claim 1, the method comprising:
providing a base substrate having circuit wiring;
mounting a plurality of LEDs in an array on the base substrate;
forming an upper optical layer on a top surface of each of the plurality of LEDs;
forming a side optical layer positioned on a lateral side of the plurality of LEDs; and
forming a black layer by carbonizing a top surface of the side optical layer by radiating a laser onto the side optical layer.

19. A display device comprising:
a display module having a plurality of light emitting diode (LED) panels disposed in an array;
a frame allowing the plurality of LED panels to mounted therein; and
a controller connected to the display module to control the display module,
wherein each of the LED panels comprises:
a base substrate comprising circuit wiring;
a plurality of LEDs disposed in an array on the base substrate;
a side optical layer positioned on a lateral side of the plurality of LEDs, the side optical layer containing a diffusion agent; and
an upper optical layers positioned on a top surface of each of the LEDs and containing a diffusion agent.
